Europäisches Patentamt

European Patent Office

Office européen des brevets

(19)

(11) Publication number: **0 017 143**
**B1**

# EUROPEAN PATENT SPECIFICATION

(12)

(45) Date of publication of patent specification: **13.07.83**

(21) Application number: **80101575.1**

(22) Date of filing: **25.03.80**

(51) Int. Cl.³: **H 01 J 37/32, H 05 H 1/30, H 05 H 1/46, C 23 C 15/00**

(54) Microwave plasma etching apparatus.

(30) Priority: **06.04.79 JP 41109/79**

(43) Date of publication of application:
**15.10.80 Bulletin 80/21**

(45) Publication of the grant of the patent:
**13.07.83 Bulletin 83/28**

(84) Designated Contracting States:
**DE FR GB NL**

(56) References cited:
**DE - A - 2 716 592**
**US - A - 3 677 924**
**US - A - 3 993 909**

(73) Proprietor: **Hitachi, Ltd.**
**5-1, Marunouchi 1-chome**
**Chiyoda-ku Tokyo 100 (JP)**

(72) Inventor: **Suzuki, Keizo**
**4-815-2, Nishi-koigakubo**
**Kokubunji-shi Tokyo (JP)**
Inventor: **Okudaira, Sadayuki**
**1-217, Higashi-koigakubo**
**Kokubunji-shi Tokyo (JP)**
Inventor: **Nishimatsu, Shigeru**
**6-10-17, Higashi-koigakubo**
**Kokubunji-shi Tokyo (JP)**
Inventor: **Kanomata, Ichiro**
**5-16-7, Bubai-cho**
**Fuchu-shi Tokyo (JP)**

(74) Representative: **Strehl, Peter et al,**
**Strehl, Schübel-Hopf, Schulz Patentanwälte**
**Widenmayerstrasse 17 Postfach 22 03 45**
**D-8000 München 22 (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

Microwave plasma etching apparatus

## Background of the invention

This invention relates to improvements in an etching apparatus utilizing a microwave discharge plasma, according to the first part of claim 1. Such an apparatus is known from DE—A—2 718 592.

In recent years, in the field of the surface processings of semiconductors and metals, a conventional wet processing method has been extensively changed over to a dry processing method. As one of apparatuses suitable for the dry etching of a semiconductor surface, the inventors have previously developed an etching apparatus exploiting a microwave discharge plasma (refer to (Japanese Patent Application Publication No. 44795/1978).

This microwave plasma etching apparatus is such that the surface of a sample is exposed to the plasma produced by microwave discharge, so as to etch and process the sample surface. It has the merit that a fine etching processing is possible with damages of the sample lessened. On the other hand, however, if the etching processing of the sample surface is performed in the state in which a single sample or a smaller number of samples is/are inserted and fixed in a plasma exposure region as in a conventional manner, there will be a problem in point of the processing capability. Moreover, it is feared that the continuous exposure of the sample to the plasma for a long time will raise the temperature of the sample excessively, to incur various drawbacks such as changing the quality of a photoresist mask overlying the sample surface.

As an expedient for solving the problem, there has been proposed an apparatus wherein a plurality of samples are placed on a turntable and wherein, as the turntable rotates, the plurality of samples pass through a plasma exposure region in succession (refer to Japanese Patent Application Publication No. 34463/1978). According to this method, it becomes possible to etch and process the plurality of samples simultaneously, so that the processing capability of the apparatus is markedly enhanced. In addition, since the individual samples have heating and cooling repeated periodically, the excessive temperature rise of the samples is avoided.

With this method, however, since the samples are transported within the plasma exposure region at a substantially uniform density while revolving along a circular orbit, the etching speed on the surface of each sample differs depending upon the distance from the center of the revolution, resulting in the difficulty that a uniform etching processing cannot be executed over the whole sample surface.

From US—A—3 677 924 a sputtering apparatus is known comprising a sample holder which is rotatable so as to transport the samples along a circular path which contains a portion confronting the opening of the sputtering system which opening has the shape of a fan, the pivot of which lies on the axis of rotation of the sample holder.

## Summary of the invention

It is accordingly an object of this invention to provide an apparatus construction which eliminates the differences of the etching speed on the surface of each sample attendant upon the revolving transportation of samples in the microwave plasma etching apparatus as described above and which can carry out a uniform etching processing over the entire sample surface.

In order to accomplish the object, this invention consists in a microwave plasma etching apparatus comprising:

a holder for receiving samples to be etched,

a discharge tube having an end portion of circular cross-section and an opening portion confronting the sample holder, and

means for generating a microwave discharge plasma in the discharge tube, characterized in that the sample holder is rotatable so as to transport the samples along a circular path which contains a portion confronting the opening portion of the discharge tube, and that the cross-section of the side walls within said opening portion of the discharge tube has the shape of a fan, the pivot of which lies on the axis of rotation of the sample holder. By such construction, any excessive temperature rise of the sample in the plasma is avoided. Simultaneously, all positions on the sample surface passing through the fan-shaped plasma exposure region are exposed to the plasma at an identical density for an identical period of time, so that etching speeds become equal over the whole sample surface to afford a uniform etching performance. In addition, the processing capability of the apparatus can be sufficiently raised by introducing a plurality of samples into the plasma exposure region along the circular orbit in succession.

A particular embodiment of the invention is characterized in that the discharge tube gradually tapers from its end portion of circular cross-section towards the fan-shaped opening portion.

Other objects of this invention and the resulting functional effects will become obvious from the following detailed description taken in connection with embodiments.

Hereunder, embodiments of this invention will be described in detail with reference to the accompanying drawings.

## Brief description of the drawings

Figure 1 is a vertical sectional schematic view showing an example of the general construction of a microwave plasma etching apparatus according to an embodiment of this invention,

Figure 2 is a view for explaining the cross-sectional shape of a plasma exposure region in this invention,

Figure 3 is a diagram showing the uniformity in the etching speed in the apparatus of this invention in comparison with the etching speed in a prior-art apparatus, and

Figure 4 is a perspective view showing a concrete example of construction of a discharge tube which is used for performing this invention.

Description of the preferred embodiments

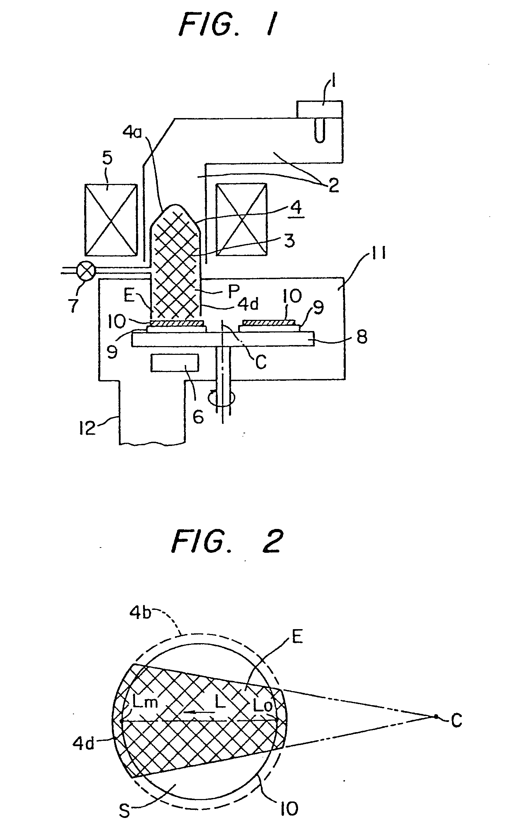

Figure 1 shows the general construction of a microwave plasma etching apparatus according to an embodiment of this invention. Referring to the figure, microwaves generated by a microwave oscillator 1 are introduced through a waveguide 2 into a discharge chamber 3 which is formed in a discharge tube 4. The interior of the discharge chamber 3 is hermetically sealed from the side of the waveguide 2 by means of an upper-end sealing portion 4a of the discharge tube 4 which is made of a heat-resisting dielectric substance (for example, quartz, alumina or the like). The lower end of the discharge chamber 3 communicates with a sample chamber 11 through a lower-end opening portion 4d of the discharge tube 4. The internal space of the sample chamber 11 is exhausted into a vacuum through an exhaust pipe 12. In the discharge chamber 3, a magnetic field in the axial direction is applied by a solenoid coil 5 and a permanent magnet 6. A discharge gas (for example, Ar, $O_2$, $N_2$, $CF_4$ etc.) suitable for the etching processing of a sample 10 is introduced into the discharge chamber 3 through a leak valve 7. Thus, a plasma P (hatched in the figure) based on the microwave discharge is created in the discharge chamber 3. In accordance with this invention, the plasma P is confined to a sectoral sectional shape by the sectoral sectional portion 4d of the discharge tube 4 in the lower-end opening portion (plasma exposure region) E of the discharge chamber 3.

A plurality of sample stands 9 are disposed on an identical circumference on a turntable 8, and the samples 10 are placed on the respective sample stands. Accordingly, the samples 10 are transported while revolving on a circular orbit by the rotation of the turntable 8, whereby they are successively introduced into the plasma exposure region E and subjected to the etching processing therein. Since each sample alternately undergoes heating inside the plasma exposure region E and cooling outside it, any excessive temperature rise of the sample is prevented.

Figure 2 is an explanatory view of the sectional shape of the plasma exposure region E (region hatched in the figure). As stated above, the plasma exposure region E is sectoral or fan-shaped in such a way that the plasma is confined by the sectoral sectional portion 4d of the discharge tube 4. The center of the sector (a point corresponding to the pivot of the fan) coincides with the center (center of the circular orbit) C of the revolution of the sample 10 by the turntable 8. Accordingly, when the sample 10 revolves on the circular orbit about the point C (the sample does not rotate about its own axis), the periods of time for which various points on the surface S of the sample exist within the plasma exposure region E become constant irrespective of distances from the center C of the revolution. That is, the various points on the sample surface are exposed to the plasma at an identical density for equal periods of time, so that the uniformity of the etching speed is held.

In contrast, assuming that in Figure 2, the plasma exposure region E has the same circular sectional shape as that of the circular sectional portion 4b of the discharge tube 4, the periods of time for which the various points on the sample surface lie within the plasma exposure region are different depending upon the distances from the center C of the revolution, so that the uniformity of the etching speed cannot be attained.

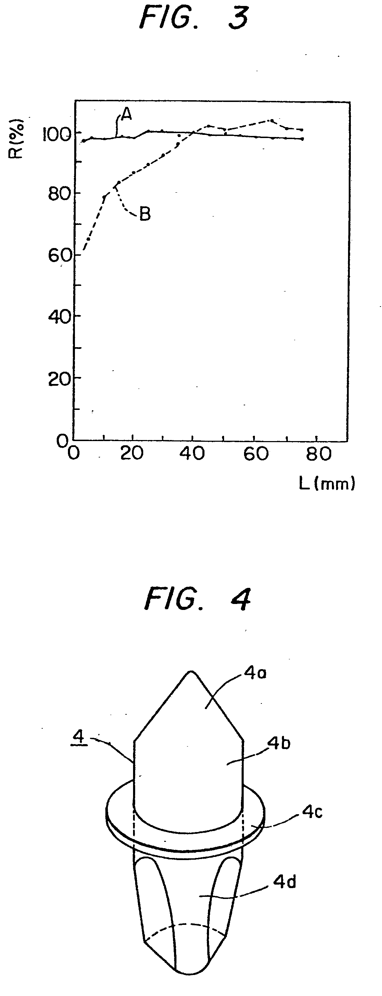

Figure 3 shows an example of the comparative measurement of the uniformity of the etching speed at the time when, while revolving samples, etching processings were carried out in cases where the cross-sections of the plasma exposure regions were sectoral (curve A) and circular (curve B). The example is of silicon wafers each having a diameter of 76 mm. The axis of abscissas indicates the radial distance L (mm) measured from a sample end $L_o$ which is the nearest to the center of revolution C in Figure 2, towards another sample end $L_m$ which is the remotest from the same. The axis or ordinates indicates the etching speed ratio R (%) with 100% being the maximum etching speed in the case of the curve A. The standard deviation value in the curve A was 0.96%, while that in the curve B was 10.9%. It is accordingly understood that the uniformity of the etching speed is enhanced approximately 10 times by making the cross-sectional shape of the plasma exposure region sectoral.

Figure 4 shows an example of the concrete structure of the discharge tube 4 for performing this invention. The material of the discharge tube 4 is a heat-resisting dielectric such as alumina or quartz. In order to execute a hermetic sealing between the discharge tube 4 and the upper wall of the sample chamber 11, a vacuum sealing flange portion 4c is provided. Thus, the position of a vacuum sealing O-ring can be made remote from the inner wall of the discharge tube to come into contact with the plasma, and any thermal damage of the O-ring is prevented. Microwave power is principally absorbed by a tapered portion 4a and a cylindrical portion 4b. The tapered portion 4a serves to smooth the microwave coupling with the microwave waveguide 2 in Figure 1, whereby the microwave power is efficiently introduced into the discharge space. The tapered portion 4a and the cylindrical portion 4b form an axially symmetric structure, whereby a plasma of good uniformity is produced.

In order to form the cross-section of the plasma exposure region into a sector, the lower end part of the discharge tube 4 is shaped into a sectoral cross-section. To this end, a sectional form-controlling portion 4d is gradually tapered from the cylindrical portion 4b towards the sectoral end part. When the cross-sectional shape of the plasma is fined by the side wall surface of the discharge tube 4, the plasma collides against this side wall surface. However, since the portion 4d is gradually tapered as described above, the uniformity of the plasma density within the discharge tube is hardly disturbed by the plasma colliding here. In addition, since the heat radiating portion is of a large area, overheating of the discharge tube is effectively prevented.

When the plasma is not satisfactorily uniform in the plasma exposure region extending along the sample surface, the shape of the plasma exposure region needs to be somewhat changed from the perfect sector in accordance with the extent of non-uniformity. In this case, the uniformity of the plasma density within the plasma exposure region is experimentally measured, whereupon the sectoral shape may be changed to some extent.

At apparent from the above detailed description, according to this invention, owing to the very simple construction, any temperature rise of the sample in the microwave plasma etching apparatus can be prevented, and the uniformity of the etching speed can be enhanced. This invention is greatly effective when put into practical use.

## Claims

1. A microwave plasma etching apparatus comprising:

a holder (8) for receiving samples (10) to be etched,

a discharge tube (4) having an end portion (4b) of circular cross-section and an opening portion (4d) confronting the sample holder, and

means (1, 2, 5, 6) for generating a microwave discharge plasma in the discharge tube, characterized in that the sample holder (8) is rotatable so as to transport the samples (10) along a circular path which contains a portion confronting the opening portion (4d) of the discharge tube (4), and that the cross-section of the side walls within said opening portion of the discharge tube has the shape of a fan, the pivot (C) of which lies on the axis of rotation of the sample holder.

2. The apparatus of claim 1, characterized in that the discharge tube (4) gradually tapers from its end portion (4b) of circular cross-section towards the fan-shaped opening portion (4d).

## Patentansprüche

1. Mikrowellen-Plasmaätzvorrichtung, umfassend

einen Halter (8) zur Aufnahme von zu ätzenden Proben (10),

ein Entladungsrohr (4), das einen Endabschnitt (4b) mit kreisförmigem Querschnitt und einen dem Probenhalter gegenüberstehenden Öffnungsabschnitt (4d) aufweist, und

eine Einrichtung (1, 2, 5, 6) zur Erzeugung eines Mikrowellen-Entladungsplasmas in dem Entladungsrohr, dadurch gekennzeichnet, daß der Probenhalter (8) derart drehbar ist, daß er die Proben (10) auf einer kreisförmigen Bahn transportiert, die einen dem Öffnungsabschnitt (4d) des Entladungsrohrs (4) gegenüberstehenden Abschnitt enthält, und daß der Querschnitt der Seitenwände innerhalb des Öffnungsabschnitts des Entladungsrohrs die Form eines Windflügels hat, dessen Drehpunkt (C) auf der Drehachse des Probenhalters liegt.

2. Vorrichtung nach Anspruch 1, dadurch gekennzeichnet, daß das Entladungsrohr (4) sich von seinem Endabschnitt (4b) mit kreisförmigem Querschnitt in Richtung des windflügelförmigen Öffnungsabschnitts (4d) allmählich verjüngt.

## Revendications

1. Appareil de corrosion plasmatique à micro-ondes comportant un porte-échantillons (8) destiné à recevoir des échantillons (10) devant être soumis à une corrosion, un tube à décharge (4) comportant une partie d'extrémité (4b) de section transversale circulaire et une partie formant ouverture (4d) située en vis-à-vis du porte-échantillons, et des moyens (1, 2, 5, 6) pour produire un plasma de décharge à micro-ondes dans le tube à décharge, caractérisé en ce que le porte-échantillons (8) peut tourner de manière à déplacer les échantillons (10) le long d'un trajet circulaire incluant une partie située en vis-à-vis de la partie formant ouverture (4d) du tube à décharge (4), et que la section transversale des parois latérales à l'intérieur de ladite partie formant ouverture du tube à décharge possède la forme d'une fente, dont le centre de rotation (C) est situé sur l'axe de rotation du porte-échantillons.

2. Appareil selon la revendication 1, caractérisé en ce que le tube à décharge (4) se rétrécit graduellement depuis sa partie d'extrémité (4b) possédant une section transversale circulaire en direction de la partie formant ouverture (4d) en forme de fente.

# FIG. 1

# FIG. 2

# FIG. 3

# FIG. 4